(19) **Europäisches Patentamt**

**European Patent Office**

**Office européen des brevets**

(11) **EP 1 330 029 A2**

(12) **EUROPÄISCHE PATENTANMELDUNG**

(43) Veröffentlichungstag:
**23.07.2003 Patentblatt 2003/30**

(51) Int Cl.7: **H03H 17/02**, H03H 17/06

(21) Anmeldenummer: **02026740.7**

(22) Anmeldetag: **30.11.2002**

(84) Benannte Vertragsstaaten:
**AT BE BG CH CY CZ DE DK EE ES FI FR GB GR IE IT LI LU MC NL PT SE SK TR**
Benannte Erstreckungsstaaten:
**AL LT LV MK RO SI**

(30) Priorität: **19.01.2002 DE 10201902**

(71) Anmelder: **Continental Aktiengesellschaft 30165 Hannover (DE)**

(72) Erfinder:
• **Creutzburg, Uwe, Dr.**
  **30161 Hannover (DE)**

• **Hoinkhaus, Hermann**
  **30938 Burgwede/Fuhrberg (DE)**
• **Rieckmann, Andreas**
  **30171 Hannover (DE)**

(74) Vertreter: **Finger, Karsten**
  **Continental Aktiengesellschaft**
  **Patente und Lizenzen**
  **Postfach 169**
  **30001 Hannover (DE)**

(54) **Verfahren zur digitalen Filterung eines mit Rauschen behafteten Signals und Regelungssystem für ein Fahrzeug**

(57) Die Erfindung betrifft ein Regelungssystem für ein Fahrzeug und ein Verfahren zur digitalen Filterung eines mit Rauschen behafteten Signals zur Ausfilterung des Rauschanteils mit folgenden Schritten:

- Eingabe des Signals in einen digitalen Filter einer Filterlänge (K+1), wobei die Filterlänge kleiner als die Periode der Grundfrequenz des Signals ist,

- Ausfilterung eines Signalanteils einer Ordnung (m) aus dem Signal, basierend auf zurückliegenden Abtastwerten des Signals innerhalb der Filterlänge,

- Ausgabe eines gefilterten Signalwerts.

EP 1 330 029 A2

**Beschreibung**

Die Erfindung betrifft ein Verfahren zur digitalen Filterung eines mit Rauschen behafteten Signals zur Ausfilterung des Rauschanteils, insbesondere um einen Nulldurchgang des Signals festzustellen, sowie ein Verfahren zur Regelung der Fahrdynamik eines Fahrzeugs und ein entsprechendes Computerprogramm und Regelungssystem.

Aus dem Stand der Technik sind verschiedene Verfahren zur digitalen Filterung bekannt, insbesondere sogenannte Butterworth-Filter. Des weiteren sind an sich auch sogenannte adaptive und prediktive Filter aus dem Stand der Technik bekannt.

Ebenso ist es aus dem Stand der Technik bekannt, digitale Filter zur Tiefpassfilterung von mit Rauschen behafteten Signalen zur Ausfilterung des Rauschanteils zu verwenden. Ein gemeinsamer Nachteil solcher digitaler Filter ist die durch die Filterung erzeugte Phasenverschiebung des gefilterten Signals mit Bezug auf das Ursprungssignal. Diese Phasenverschiebung ist insbesondere für regelungstechnische Anwendungen nachteilig, da es hier auf eine genaue Phasenlage ankommt. Dies gilt auch für regelungstechnische Anwendungen für Fahrzeuge, insbesondere Kraftfahrzeuge.

Aus der DE 41 12 007 A1 ist ein System zur Bildung eines Signals für die Fahrwerkregelung eines Fahrzeugs bekannt, bei dem die Relativbewegungen zwischen Fahrzeugaufbau und Rädern erfasst werden. Hiervon ausgehend wird die prädizierte Einfedergeschwindigkeit zu einem zukünftigen Zeitpunkt ermittelt. Hierauf basierend wird die Steuerung einer Fahrzeuggröße, wie die Ansteuerung von verstellbar ausgelegten Dämpfern, vorgenommen. Die Zielsetzung ist hierbei, die Verstellung der Dämpfercharakteristik in Betriebsphasen geringer Dämpfungskräfte des Dämpfers zu tätigen, um die Verstellgeräusche der Dämpfung zu minimieren.

Nachteilig ist hierbei, dass für die Prädizierung der Einfedergeschwindigkeit eine Taylor-Reihen Entwicklung verwendet wird. Eine solche Taylor-Reihen Entwicklung basiert per Definition auf Ableitungen, die Rauschanteile in dem Signal verstärken. Deshalb muss bei diesem Ansatz die Reihenentwicklung "früh" abgebrochen werden, so dass nur eine sehr kleine Anzahl von Stützstellen berücksichtigt werden kann. Ferner wird bei diesem Verfahren angenommen, dass die berücksichtigten Stützstellen "wahre", d. h. nicht rauschbehaftete Signalwerte sind, so dass Messungenauigkeiten zu massiven Auswirkungen auf die Prädiktion führen.

Der Erfindung liegt daher die Aufgabe zugrund, ein verbessertes Verfahren zur digitalen Filterung eines mit Rauschen behafteten Signals zur Ausfilterung des Rauschanteils zu schaffen sowie ein verbessertes Verfahren zur Regelung der Fahrdynamik eines Fahrzeugs und ein entsprechendes Computerprogramm und Regelungssystem.

Die der Erfindung zugrund liegende Aufgabe wird mit den Merkmalen der unabhängigen Patentansprüche jeweils gelöst. Bevorzugte Ausführungsformen der Erfindung sind in den abhängigen Patentansprüchen angegeben.

Ein besonderer Vorteil der Erfindung liegt darin, dass das gefilterte Signal nur eine geringe oder keine Phasenverschiebung mit Bezug auf das ungefilterte mit Rauschen behaftete Signal aufweist. Dies trifft insbesondere für die Filterung des linear approximierten Signalsverlaufs zu, so dass der Zeitpunkt des Durchgangs des mit Rauschen behafteten Signals durch einen bestimmten Signalpegel durch Auswertung des gefilterten Signals besonders genau ermittelt werden kann. Auf diese Art und Weise ist insbesondere der Zeitpunkt des Null-Durchgangs genau feststellbar.

Ein weiterer besonderer Vorteil der Erfindung liegt darin, dass ein FIR-Filter (Finit-Impuls-Response) verwendet werden kann, so dass der Filter in jedem Fall stabil ist.

Nach einer bevorzugten Ausführungsform der Erfindung wird ein FIR-Filter einer bestimmten Filterlänge verwendet, die wesentlich kleiner als die Periode der Grundfrequenz des zu filternden Signals ist. Beispielsweise wird die Filterlänge als 1/5 oder als ein 1/10 der Periode der Grundfrequenz gewählt.

Dies ist insbesondere für solche Signale vorteilhaft, die von einem Schwingungssystem herrühren, da diese Signale im allgemeinen einen starken harmonischen Anteil der Grundfrequenz aufweisen und dieser harmonische Anteil im Bereich des Nulldurchgangs linear approximiert werden kann. Für solche Signale ist entsprechend eine Auslegung des Filters zur Ausfilterung des linearen Signalanteils vorteilhaft, so dass der Nulldurchgang des Signals besonders genau bestimmt werden kann.

Nach einer weiteren bevorzugten Ausführungsform der Erfindung erfolgt die Filterung durch Interpolation basierend auf zurückliegenden Abtastwerten innerhalb einer durch die Filterlänge vorgegebenen Fensterlänge. Alternativ oder zusätzlich erfolgt die Filterung durch Extrapolation basierend auf denselben Abtastwerten, um zu einem extrapolierten zukünftigen Signalwert zu gelangen. Die Extrapolation kann insbesondere dazu benutzt werden, zukünftige Signalwerte, zum Beispiel den Null-Durchgang, zu schätzen, oder Signalwerte für bestimmte zurückliegende oder zukünftige Zeitpunkte zu berechnen.

Nach einer weiteren bevorzugten Ausführungsform der Erfindung erfolgt die Ausfilterung eines nicht linearen Signalanteils, beispielsweise eines Signalanteils quadratischer oder höherer Ordnung. Zur Ausfilterung von Signalanteilen quadratischer Ordnung wird ein quadratischer Interpolationsalgorithmus verwendet, um entsprechende nichtlineare Signalverläufe auszufiltern.

Nach einer weiteren bevorzugten Ausführungsform der Erfindung wird zur Ausfilterung eines linearen Signalanteils die Filterlänge so gewählt, dass der Signalverlauf des zu filternden Signals innerhalb eines relevanten Bereichs einen im Wesentlichen linearen Verlauf hat. Bei einem Schwingungssignal trifft dies für den Bereich um den Nulldurchgang des Signals zu, der sich durch eine lineare Funktion approximieren lässt.

Nach einer bevorzugten Ausführungsform der Erfindung wird das erfindungsgemäße Verfahren zur digitalen Filterung als Grundlage für die Regelung eines oder mehrerer fahrdynamischer Parameter eines Fahrzeugs verwendet. Etwa für die Regelung der Dämpfung werden zu bestimmten Abtastzeitpunkten die Eingangssignale von Höhenstandsensoren erfasst und das entsprechende mit Rauschen behaftete Signal gefiltert und dem Regelalgorithmus zugeführt. Beispielsweise erfolgt die Regelung der Dämpfercharakteristik adaptiv basierend auf der Dedektion des Null-Durchgangs des Signals.

Bevorzugte Ausführungsbeispiele der Erfindung werden im Weiteren mit Bezugnahme auf die Bezeichnungen näher erläutert. Es zeigen:

Figur 1      ein Blockdiagramm einer Ausführungsform eines erfindungsgemäßen digitalen Filters,

Figur 2      ein Blockdiagramm eines Testsystems zur Veranschaulichung der Wirkungsweise des erfindungsgemäßen digitalen Filters,

Figur 3      die Verläufe von Signalen in dem Testsystem der Figur 2,

Figur 4      eine Ausführungsform des erfindungsgemäßen Verfahrens zur Durchführung einer Regelung basierend auf einer Erkennung des Nulldurchgangs,

Figur 5      eine Ausführungsform des erfindungsgemäßen Regelungssystems für ein Kraftfahrzeug.

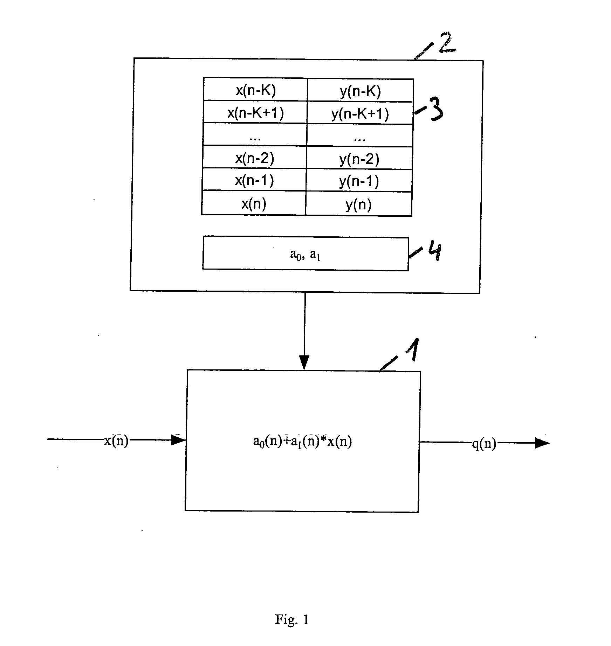

Die Figur 1 zeigt einen linearen adaptiven FIR-Filter 1 mit der Filterfunktion

$$a_0(n)+a_1(n)*x(n)$$

wobei:

     $x(n)$: n-ter Abtastzeitpunkt,
     $a_0(n)$:Filterparameter $a_0$ für den n-ten Abtastzeitpunkt,
     $a_1(n)$: Filterparameter $a_1$ für den n-ten Abtastzeitpunkt.

Der gefilterte Signalwert, d. h. der Ausgang des Filters 1, wird mit $q(n)$ bezeichnet.

Die Filterparameter $a_0(n)$ und $a_1(n)$ werden für jede Berechnung eines gefilterten Signalwerts $q(n)$ neu berechnet. Hierzu dient die Adaptionseinheit 2, die einen Speicher 3 und einen Rechner 4 aufweist. Der Speicher 3 dient zur Speicherung von aktuellen und zurückliegenden Abtastzeitpunkten $x(n)$, $x(n-1)$, ..., $x(n-K)$ und von zurückliegenden Abtastwerten des verrauschten Signals $y(n)$, $y(n-1)$, ..., $y(n-K)$. In dem Speicher 3 werden also K zurückliegende Abtastzeitpunkte und Abtastwerte gespeichert. Dies entspricht zugleich einer Filterlänge von K, d. h. die Filterlänge ergibt sich aus $K-T_s$, wobei $T_s$ die Abtastzeit ist.

Aus den zurückliegenden Abtastzeitpunkten x und den zurückliegenden Abtastwerten y des Speichers 3 werden für die Berechnung des n-ten gefilterten Signalwert $q(n)$ die Filterparameter $a_0$ und $a_1$ mit dem Rechner 4 bestimmt. Für die Berechnung eines nachfolgenden n+1 ten Signalwerts $q(n+1)$ werden die am längsten zurückliegenden Abtastzeitpunkte $x(n-K)$ und Abtastwerte $y(n-K)$ aus dem Speicher 3 gelöscht und der aktuelle Abtastzeitpunkt $x(n+1)$ und Abtastwert $y(n+1)$ werden in den Speicher 3 geschoben, so dass die Berechnung der Filterparameter $a_0$ und $a_1$ in dem Rechner 4 basierend auf diesem angepassten Satz von zurückliegenden Abtastzeitpunkten und Abtastwerten erfolgt.

Mittels der Filterfunktion des Filters 1 wird ein linearer Signalanteil aus den Abtastwerten $y(n)$ des mit Rauschen behafteten Signals ausgefiltert. Der gefilterte Signalwert $q(n)$ zum n-ten Zeitpunkt ergibt sich durch Interpolation aus den zurückliegenden Abtastzeitpunkten und Abtastwerten der Filterlänge.

Zusätzlich oder alternativ kann neben der Berechnung des n-ten gefilterten Signalwerts $q(n)$ auch der zukünftige Signalwert $q(n+i)$ durch Extrapolation berechnet werden. Hierzu werden die Filterparameter $a_0$ und $a_1$ zum n-ten Zeitpunkt verwendet. Dies bedeutet, dass sich der gefilterte Signalwert $q(n+i)$ durch Extrapolation, basierend auf den hinter dem n-ten Zeitpunkt zurückliegenden Abtastzeitpunkten und Abtastwerten ergibt.

Beispielsweise im Bereich des Nulldurchgangs eines verrauschten sinnesförmigen Signals liefert eine solche Extrapolation relativ genaue Ergebnisse, da sich die Grundschwingung des Signals näherungsweise sinusförmig verhält und sich damit linear approximieren lässt. Dadurch wird es möglich, z. B. den Zeitpunkt des Nulldurchgangs vorherzusagen. Auch der vorhergesagte Nulldurchgang kann als Eingangsgröße für eine Regelung, z. B. der Fahrdynamik eines Fahrzeugs dienen.

Zur Ausfilterung von Signalanteilen höherer Ordnung muss die Filterfunktion des Filters 1 entsprechend erweitert werden. Zur Ausfilterung von Signalanteilen m-ter Ordnung ist eine Filterfunktion in Form eines Polynoms m-ter Ordnung erforderlich.

Für die lineare Filterfunktion des Filters 1 können die Filterparameter $a_0$ und $a_1$ basierend auf den in dem Speicher 3 gespeicherten zurückliegenden Abtastzeitpunkten x und Abtastwerten y von dem Rechner 4 wie folgt berechnet werden:

$$a_0(n) = \frac{\sum_{k=0}^{K} y(n-k) \sum_{k=0}^{K} x^2(n-k) \quad - \sum_{k=0}^{K} x(n-k) \sum_{k=0}^{K} \left[ x(n-k)\, y(n-k) \right]}{D(n)}$$

$$a_1(n) = \frac{K \sum_{k=0}^{K} \left[ x(n-k)\, y(n-k) \right] \quad - \sum_{k=0}^{K} x(n-k) \sum_{k=0}^{K} y(n-k)}{D(n)}$$

wobei

$$D(n) = K \sum_{k=0}^{K} x^2(n-k) \quad - \left[ \sum_{k=0}^{K} x(n-k) \right]^2$$

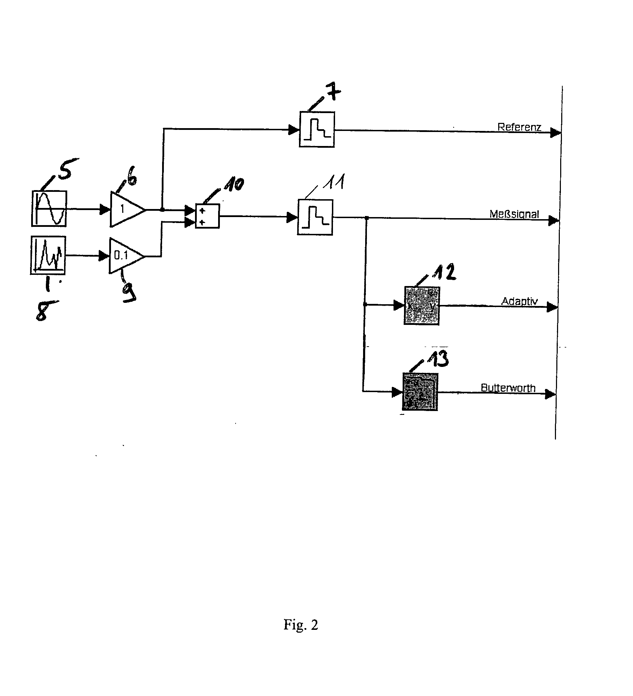

Die Figur 2 zeigt ein Testsystem zur Veranschaulichung der Wirkung des Filters 1 der Figur 1. Das Testsystem beinhaltet einen Signalgenerator 5 zur Erzeugung eines sinusförmigen Signals. Dieses sinusförmige Signal wird in dem Verstärker 6 mit dem Verstärkungsfaktor 1 gewichtet und von dem analog-digital Wandler 7 abgetastet. Daraus ergibt sich das Referenzsignal "Referenz".

Das Testsystem hat ferner einen Rauschgenerator 8. Das von dem Rauschgenerator 8 erzeugte Rauschen wird von dem Verstärker 9 mit dem Faktor 0,1 gewichtet. Die Ausgangssignale der Verstärker 6 und 9 werden in dem Summierer 10 aufaddiert und danach von dem analog-digital Wandler 11 abgetastet. Daraus ergibt sich das als "Messsignal" bezeichnete Signal. Dies entspricht einem von einem Sensor z.B. in einem Kraftfahrzeug abgegebenen mit Rauschen behafteten Signal.

Das mit Rauschen behaftete Messsignal wird dem adaptiven Filter 12 zugeführt, welcher in Aufbau und Funktionsweise dem mit Bezug auf die Figur 1 erläuterten Filter entspricht. Dieser gibt das gefilterte Signal "Adaptiv" aus. Ferner wird das "Messsignal" auch in einen Tiefpassfilter 13 eingegeben. Bei diesem Tiefpassfilter 13 handelt es sich um einen an sich aus dem Stand der Technik bekannten Butterworth-Filter.

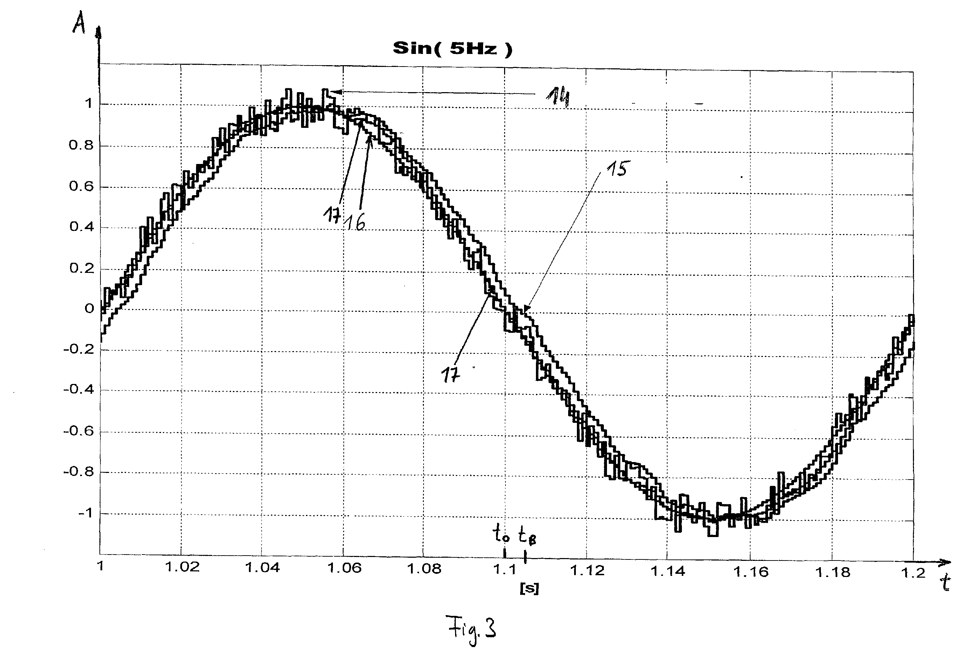

Die entsprechenden Signalverläufe sind in der Figur 3 dargestellt. Das mit Rauschen behaftete Messsignal ist in der Figur als Signal 14 bezeichnet. Das Ausgangssignal des Butterworth-Filters 13 ist in der Figur 3 mit 15 bezeichnet. Das Referenzsignal ist in der Figur 3 mit 16 bezeichnet und das Ausgangssignal des Filters 12 "Adaptiv" wird in der Figur 3 mit 17 bezeichnet.

Die Signale 17 und 16 sind insbesondere im Bereich um den Nulldurchgang weitestgehend deckungsgleich, so dass der Zeitpunkt des Nulldurchgangs $t_0$ des gefilterten Signals 17 mit dem des Referenzsignals 16 übereinstimmt. Dagegen weist das Signal 15, d. h. das Ausgangssignal des Butterworth-Tiefpassfilters 13 eine deutliche Phasenverschiebung im Vergleich zu dem Referenzsignal auf. Der Nulldurchgang des Signals 15 erfolgt zu einem Zeitpunkt $t_B$ deutlich nach dem tatsächlichen Nulldurchgang zum Zeitpunkt $t_0$. Auch in den Signalbereichen außerhalb des Nulldurchgangs ist das adaptiv gefilterte Signal 17 dem Butterworth gefilterten Signal 15 überlegen und hat eine bessere Approximation an das Referenz-Signal 16, insbesondere eine kleinere Phasenverschiebung.

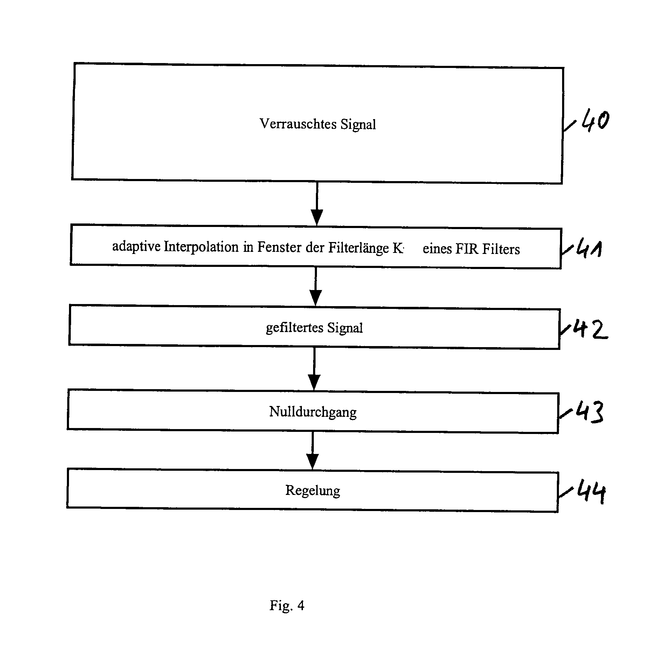

Die Figur 4 zeigt eine Ausführungsform des erfindungsgemäßen Regelungsverfahrens.

In dem Schritt 40 wird ein mit Rauschen behaftetes Signal eingegeben, welches beispielsweise von einem Sensor stammt. Dieses Signal wird mittels eines Filters der in der Figur 1 gezeigten Art gefiltert, und zwar durch adaptive Interpolation, basierend auf einem Fenster von zurückliegenden Werten der Filterlänge K.

In dem Schritt 42 wird das entsprechend gefilterte Signal ausgegeben. In dem Schritt 43 wird für das gefilterte Signal ein Nulldurchgang ermittelt. Der Zeitpunkt des Nulldurchgangs des gefilterten Signals wird in dem Schritt 44 einer Regelung zugeführt, die basierend auf diesem Zeitpunkt eine Regelung beispielsweise der Dämpfung eines Fahrzeugdämpfers vornimmt.

Neben der Interpolation ist auch eine Extrapolation möglich, wie mit Bezug auf die Figur 1 oben erläutert. Durch Extrapolation kann der Verlauf, in diesem Fall der Nulldurchgang, des gefilterten Signals in dem Schritt 43 vorhergesagt werden. Der vorhergesagte Zeitpunkt z. B. des Nulldurchgangs kann dann alternativ oder zusätzlich für die Regelung in dem Schritt 44 verwendet werden.

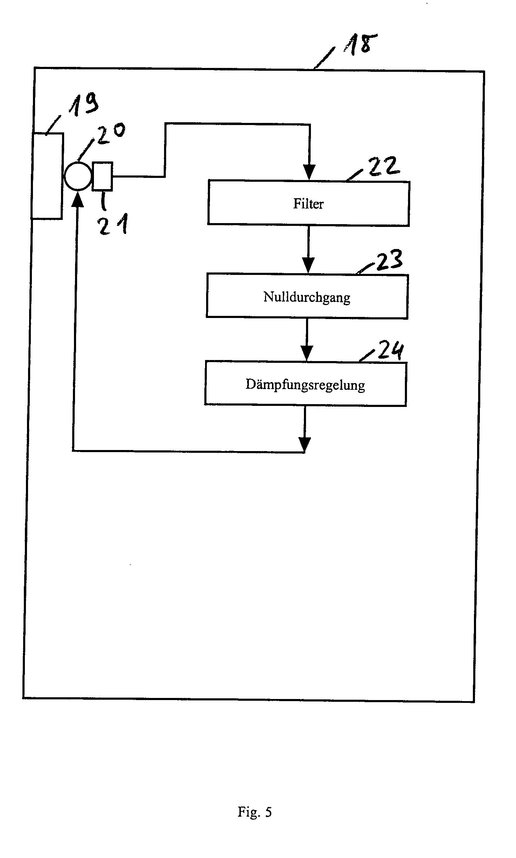

Die Figur 5 zeigt eine Anwendung des erfindungsgemäßen digitalen Filterungsverfahrens für ein Kraftfahrzeug 18. Das Kraftfahrzeug 18 hat an jedem Rad 19 einen Dämpfer 20. Der Höhenstand des Dämpfers 20 wird von einem Sensor 21 erfasst, der ein entsprechendes Ausgangssignal abgibt. Dieses Ausgangssignal weist typischerweise Rauschanteile auf. Das Ausgangssignal des Sensor 21 wird in einen Filter 22 eingegeben, der in Aufbau und Wirkungsweise dem Filter der Figur 1 entspricht. Der aus dem Filter 22 ausgegebene gefilterte Signalwert wird in den Nulldurchgangsdetektor 23 eingegeben, der hierauf basierend den aktuellen und/oder zukünftigen Nulldurchgang des Signals bestimmt.

Der aktuelle und/oder zukünftige Zeitpunkt des Nulldurchgangs wird von dem Nulldurchgangsdetektor 23 in die Dämpfungsregelung 24 eingegeben, die entsprechend einem oder mehrere Dämpfungsparameter des Dämpfers 20 nachregelt.

Dieses Verfahren kann analog auch angewendet werden, um andere Signalpegel als den Nullruchgang zu detektieren.

**Bezugszeichenliste**

(ist Teil der Beschreibung)

| | |
|---|---|
| Filter | 1 |
| Adaptionseinheit | 2 |
| Speicher | 3 |
| Rechner | 4 |
| Signalgenerator | 5 |
| Verstärker | 6 |
| Analog-Digital Wandler | 7 |
| Rauschgenerator | 8 |
| Verstärker | 9 |
| Summierer | 10 |
| Analog-Digital Wandler | 11 |
| Filter | 12 |
| Filter | 13 |
| Signal | 14 |
| Signal | 15 |
| Signal | 16 |
| Signal | 17 |
| Kraftfahrzeug | 18 |
| Rad | 19 |
| Dämpfer | 20 |
| Sensor | 21 |
| Filter | 22 |
| Nulldurchgangsdetektor | 23 |
| Dämpfungsregelung | 24 |
| Schritt | 40 |
| Schritt | 42 |
| Schritt | 43 |
| Schritt | 44 |

**Patentansprüche**

1. Verfahren zur digitalen Filterung eines mit Rauschen behafteten Signals zur Ausfilterung des Rauschanteils mit folgenden Schritten:

   - Eingabe des Signals in einen digitalen Filter einer Filterlänge (K), wobei die Filterlänge kleiner als die Periode der Grundfrequenz des Signals ist,

   - Ausfilterung eines Signalanteils einer Ordnung (m) aus dem Signal, basierend auf zurückliegenden Abtastwerten des Signals innerhalb der Filterlänge,

   - Ausgabe eines gefilterten Signalwerts.

2. Verfahren nach Anspruch 1, wobei die Filterlänge weniger als 1/4, vorzugsweise weniger als 1/5, insbesondere 1/10 der Periode der Grundfrequenz des Signals beträgt.

3. Verfahren nach Anspruch 1 oder 2, wobei es sich bei dem gesuchten Signalanteil um einen linearen Signalanteil handelt.

4. Verfahren nach Anspruch 1, 2 oder 3, wobei es sich bei dem gefilterten Signalwert um einen aus den zurückliegenden Abtastwerten interpolierten Signalwert handelt.

5. Verfahren nach Anspruch 1, 2 oder 3, wobei es sich bei dem gefilterten Signalwert um einen aus den zurückliegenden Abtastwerten extrapolierten Signalwert handelt.

6. Verfahren nach einem der vorhergehenden Ansprüche 1 bis 5, wobei das Signal (y) zu diskreten Zeitpunkten (x(n)) abgetastet wird und wobei ein linearer adaptiver Filter für die Ausfilterung des Signalanteils verwendet wird, und zur Berechnung der Filterkoeffizienten des linearen adaptiven Filters auf einen Speicher zugegriffen wird, der die zurückliegenden Abtastwerte und diskreten Zeitpunkte innerhalb der Filterlänge (K) beinhaltet.

7. Verfahren nach einem der vorhergehenden Ansprüche 1 bis 6, wobei ein Nulldurchgang des mit Rauschen behafteten Signals mittels der gefilterten Signalwerte bestimmt wird.

8. Verfahren nach einem der vorhergehenden Ansprüche 1 bis 7, wobei es sich bei dem mit Rauschen behafteten Signal um das Ausgangssignal eines Sensors für ein Schwingungssystem, z. B. eines Fahrzeugs, handelt.

9. Verfahren zur Regelung der Fahrdynamik eines Fahrzeugs mit folgenden Schritten:

   - Filterung eines Ausgangssignals eines Sensors zur Erfassung einer Schwingung des Fahrzeugs nach einem Verfahren nach einem der vorhergehenden Ansprüche 1 bis 8,

   - Bestimmung des Zeitpunkts der Erreichung eines vorgegebenen Werts des Ausgangssignals, insbesondere des Nulldurchgangs, mittels der gefilterten Signalwerte,

   - Regelung eines oder mehrerer fahrdynamischer Parameter des Fahrzeugs basierend auf dem Zeitpunkt.

10. Verfahren nach Anspruch 9, wobei es sich bei dem Parameter um die Dämpfung eines Dämpfers des Fahrzeug handelt.

11. Computerprogrammprodukt zur Durchführung eines Verfahren nach einem der vorhergehenden Ansprüche 1 bis 10.

12. Regelungssystem für ein oder mehrere fahrdynamische Parameter eines Fahrzeugs mit

   - zumindest einem Sensor (21) zur Erfassung einer Schwingung des Fahrzeugs oder eines Fahrzeugteils,

   - Rechnermitteln (22, 23) zur Durchführung eines Verfahrens zur digitalen Filterung des Sensorausgangsignals nach einem der vorhergehenden Ansprüche 1 bis 8 und zur Bestimmung des Zeitpunkts der Erreichung eines vorgegebenen Werts des Ausgangssignals, insbesondere des Nulldurchgangs, aus dem gefilterten Signalwert,

- Regelungsmitteln (24) zur Anpassung des oder der fahrdynamischen Parameter basierend auf der Bestimmung des Nulldurchgangs.

**13.** Regelungssystem nach Anspruch 12, wobei es sich bei dem Parameter um die Dämpfung eines Dämpfers (20)
des Fahrzeugs handelt.

| x(n-K) | y(n-K) |
| --- | --- |
| x(n-K+1) | y(n-K+1) |
| ... | ... |
| x(n-2) | y(n-2) |
| x(n-1) | y(n-1) |
| x(n) | y(n) |

| |
| --- |
| $a_0, a_1$ |

$$a_0(n)+a_1(n)*x(n)$$

$x(n)$     $q(n)$

Fig. 1

Fig. 2

Fig. 3

Verrauschtes Signal /40

adaptive Interpolation in Fenster der Filterlänge K· eines FIR Filters /41

gefiltertes Signal /42

Nulldurchgang /43

Regelung /44

Fig. 4

18

19

20

21

22

Filter

23

Nulldurchgang

24

Dämpfungsregelung

Fig. 5